# EUROPEAN PATENT APPLICATION

(11) **EP 4 764 513 A1**
(43) Date of publication of application: **24.06.2026**
(21) Application number: 25203714.8
(22) Date of filing: 22.09.2025
(51) Int. Cl.: G01R 31/08, G01R 31/52, G01R 31/54, G01R 31/58

(54) **METHOD AND DEVICE FOR IDENTIFYING LOCATION OF FAULT IN GROUND CABLES**

(30) Priority: 22.12.2024 SA 124007607
(71) Applicant: Saudi Electricity Company, 13342 Riyadh (SA)
(72) Inventor: ALGHAMDI, Amer Abdullah A., 13342 Riyadh (SA); KHALID, Muath Khalid Omer, 13342 Riyadh (SA); ALJAHDLI, Sultan Ayed H, 13342 Riyadh (SA); ALMEHMADI, Khalid Bushaybish S, 13342 Riyadh (SA); ALDOSSARY, Ali Eid R, 13342 Riyadh (SA); ALMOALLEM, Mahmood Said A, 13342 Riyadh (SA)
(74) Representative: J A Kemp LLP

(57) **Abstract**

The present disclosure provides a method of detecting a fault in a ground cable. The method comprises monitoring the ground cable passing through an equipment of an electric substation, wherein the equipment is connected with the device. Further, detecting the fault in the ground cable based on the monitoring of the ground cable. Moving ahead, upon detecting the fault, the method performs at least one of: generating an alarm in the electric substation and a color-coded signal in a visual indicator, by the device, wherein the visual indicator activates the color-coded signal that indicates the fault on the equipment of the electric substation, based on the fault detected, and transmitting a notification message to a control center.

## Description

### TECHNICAL FIELD

The present disclosure relates generally to the technical field of electrical systems and, more particularly, to identifying the location of fault in ground cables.

### BACKGROUND

A ground cable is responsible for dissipating fault currents, stabilizing voltage levels, and protecting equipment and personnel from hazardous electrical surges. Identifying a fault in the ground cable running through an equipment in an electric substation presents significant technical challenges due to critical role the ground cable plays in ensuring the stability and safety of an electrical network. Complexity of the electric substations, with their dense network of interconnected cables, transformers, and switchgear, makes fault localization in the ground cables highly challenging. The lack of direct accessibility to buried or encased ground cables further compounds the difficulty, requiring advanced diagnostic tools and methods to identify a location of the fault.

Identifying the fault in the ground cable running through the equipment in the electric substation becomes even more challenging when theft of copper in the ground cable is involved. The ground cable, often made of high-quality copper, is a frequent target for the theft due to the material's high resale value. When sections of the ground cable are removed or replaced with inferior materials, the electrical integrity of grounding system is compromised. This not only poses significant safety risks but also makes the fault detection more complex, as the absence of continuity in the cable creates irregularities that standard diagnostic tools may struggle to interpret.

The theft of copper further complicates the process of pinpointing the fault location, as the stolen segments often result in inconsistent electrical readings or localized failures that mimic other common ground cable issues, such as corrosion or mechanical damage. Additionally, stolen or tampered cables can introduce uneven grounding resistance across equipment in the electrical substation, leading to misleading data during fault analysis. Detecting such theft-related faults requires specialized equipment and techniques, such as ground-penetrating radar or advanced continuity testing, to accurately locate the missing or tampered segments.

Addressing theft-related challenges also involves operational and logistical difficulties. The electric substations are large, complex environments where the ground cables are often buried or concealed, making routine physical inspections difficult. Furthermore, identifying theft as the root cause of a fault may require collaboration with security team and additional forensic investigation to determine the extent of the damage. These factors highlight the need for innovative approaches and integrated monitoring systems to enhance the reliability and security of ground cable networks in the electric substations.

Therefore, there is a need to efficiently identifying the location of the fault in the ground cable.

The information disclosed in this background of the disclosure section is only for enhancement of understanding of the general background of the invention and should not be taken as an acknowledgement or any form of suggestion that this information forms the prior art already known to a person skilled in the art.

### SUMMARY

One or more shortcomings discussed above are overcome, and additional advantages and features are provided by the present disclosure. Other embodiments and aspects of the disclosure are described in detail herein and are considered a part of the disclosure.

In one non-limiting embodiment of the present disclosure, a method of detecting a fault in a ground cable is disclosed. The method comprises monitoring, by a device, the ground cable passing through an equipment of an electric substation, wherein the equipment is connected with the device. The method further comprises detecting, by the device, the fault in the ground cable based on the monitoring of the ground cable. Moving ahead, upon detecting the fault, the method performs at least one of following operations. A first operation is of generating an alarm in the electric substation and a color-coded signal in a visual indicator, by the device, wherein the visual indicator activates the color-coded signal that indicates the fault in the equipment of the electric substation, based on the fault detected. A second operation is transmitting, by the device, a notification message to a control center.

In another non-limiting embodiment of the present disclosure, wherein the visual indicator activates another color-coded signal indicating a fault in the device.

In yet another non-limiting embodiment of the present disclosure, wherein the fault in the ground cable comprises a cut in the ground cable.

In yet another non-limiting embodiment of the present disclosure, wherein the detection of the fault in the ground cable is based on the monitoring, the method further comprises detecting, by the device, induced voltage on outer surface of the equipment. The method further comprises determining, by the device, that the induced voltage is greater than or equal to a pre-determined voltage threshold.

In yet another non-limiting embodiment of the present disclosure, wherein the notification message comprises electric substation data, which in turn comprises location data of the electric substation, name of the electric substation, and identity of the equipment in which the fault is detected. The notification message further comprises time data of the equipment, wherein the time data indicates occurrence time of the fault detected in the equipment of the electric substation.

In one non-limiting embodiment of the present disclosure, a device for detecting a fault in a ground cable, is disclosed. The device comprises a processing unit. The processing unit monitors the ground cable passing through an equipment of an electric substation, wherein the equipment is connected with the device. The processing unit further detects the fault in the ground cable based on the monitoring of the ground cable. Moving ahead, upon detecting the fault, the processing unit performs at least one of following operations. The processing unit in a first operation generates an alarm in the electric substation and a color-coded signal in a visual indicator, wherein the visual indicator activates the color-coded signal that indicates the fault on the equipment of the electric substation, based on the fault detected. The processing unit in a second operation transmits a notification message to a control center. Consequently, based on the fault detection, the processing unit either performs the first operation or the second operation, or both.

In another non-limiting embodiment of the present disclosure, wherein the visual indicator activates another color-coded signal indicating a fault in the device.

In yet another non-limiting embodiment of the present disclosure, wherein the fault in the ground cable comprises a cut in the ground cable.

In yet another non-limiting embodiment of the present disclosure, wherein detection of the fault in the ground cable is based on the monitoring, the processing unit is configured to detect induced voltage on outer surface of the equipment. The processing unit is further configured to determine that the induced voltage is greater than or equal to a pre-determined voltage threshold.

In yet another non-limiting embodiment of the present disclosure, wherein the notification message comprises electric substation data, which in turn comprises location data of the electric substation, name of the electric substation, and identity of the equipment in which the fault is detected. The notification message further comprises time data of the equipment, wherein the time data indicates occurrence time of the fault detected in the equipment of the electric substation.

The foregoing summary is illustrative only and is not intended to be in any way limiting. In addition to the illustrative aspects, embodiments, and features described above, further aspects, embodiments, and features will become apparent by reference to the drawings and the following detailed description.

### DESCRIPTION OF THE DRAWINGS

To easily identify the discussion of any particular element or act, the most significant digit(s) in a reference number refer(s) to the figure number in which that element is first introduced.
**FIG.** 1 illustrates an exemplary block diagram of a device for detecting a fault in a ground cable, in accordance with an embodiment of the present disclosure.
**FIG.** 2 illustrates a process flow diagram for detecting a fault in a ground cable, in accordance with an embodiment of the present disclosure.
**FIG. 3a** shows an exemplary illustration of a circuit for processing unit of the device, in accordance with an embodiment of the present disclosure.
**FIG. 3b** shows an exemplary illustration of a circuit for Universal Serial Bus (USB) interface, in accordance with an embodiment of the present disclosure.
**FIG. 3c** shows an exemplary illustration of a circuit for USB to serial interface, in accordance with an embodiment of the present disclosure.
**FIG. 3d-3e** shows an exemplary illustration of a circuit for a battery interface of the device, in accordance with an embodiment of the present disclosure.
**FIG. 3f** shows an exemplary illustration of a circuit for an alarm interface, in accordance with an embodiment of the present disclosure.
**FIG. 3g** shows an exemplary illustration of a circuit for a visual indicator interface of the device, in accordance with an embodiment of the present disclosure.
**FIG. 3h** shows an exemplary illustration of a circuit for a button interface in the device, in accordance with an embodiment of the present disclosure.
**FIG. 3i** shows an exemplary illustration of a circuit for a distance sensor interface, in accordance with an embodiment of the present disclosure.
**FIG. 3j** shows an exemplary illustration of a circuit for voltage regulation interface, in accordance with an embodiment of the present disclosure.
**FIG. 3k** shows an exemplary illustration of a circuit for a voltage detection interface, in accordance with an embodiment of the present disclosure.
**FIG. 4** illustrates an exemplary decision flow diagram for detecting a fault in a ground cable, in accordance with an embodiment of the present disclosure.
**FIG. 5** illustrates an exemplary depiction of multiple components of the device for detecting a fault in a ground cable, in accordance with an embodiment of the present disclosure.

It should be appreciated by those skilled in the art that any block diagrams herein represent conceptual views of the illustrative device embodying the principles of the present subject matter.

### DETAILED DESCRIPTION

For the purpose of promoting an understanding of the principles of the invention, reference will now be made to the various embodiments and specific language will be used to describe the same. It will nevertheless be understood that no limitation of the scope of the invention is thereby intended, such alterations and further modifications in the illustrated system, and such further applications of the principles of the invention as illustrated therein being contemplated as would normally occur to one skilled in the art to which the invention relates.

It will be understood by those skilled in the art that the foregoing general description and the following detailed description are explanatory of the invention and are not intended to be restrictive thereof.

In the present document, the word "exemplary" is used herein to mean "serving as an example, instance, or illustration." Any embodiment or implementation of the present subject matter described herein as "exemplary" is not necessarily to be construed as preferred or advantageous over other embodiments.

While the disclosure is susceptible to various modifications and alternative forms, specific embodiments thereof have been shown by way of example in the drawings and will be described in detail below. It should be understood, however, that it is not intended to limit the disclosure to the particular forms disclosed, but on the contrary, the disclosure is to cover all modifications, equivalents, and alternative falling within the spirit and the scope of the disclosure.

The terms "comprise", "comprising", or any other variations thereof, are intended to cover a non-exclusive inclusion, such that a setup, device, or method that comprises a list of components or steps does not include only those components or steps but may include other components or steps not expressly listed or inherent to such setup or device or method. In other words, one or more elements in a device or system or apparatus proceeded by "comprises... a" does not, without more constraints, preclude the existence of other elements or additional elements in the device or system or apparatus.

The terms like "at least one" and "one or more" may be used interchangeably throughout the description.

The terms like "substation", "originating substation", and "electrical substation" may be used interchangeably throughout the description.

The terms like "device", and "smart device" may be used interchangeably throughout the description.

The terms like "grounding cable", and "ground cable" may be used interchangeably throughout the description.

The terms like "voltage detector", and "voltage detector sensor" may be used interchangeably throughout the description.

In the following detailed description of the embodiments of the disclosure, reference is made to the accompanying drawings that form a part hereof, and in which are shown by way of illustration specific embodiments in which the disclosure may be practiced. These embodiments are described in sufficient detail to enable those skilled in art to practice the disclosure, and it is to be understood that other embodiments may be utilized and that changes may be made without departing from the scope of the present disclosure. The following description is, therefore, not to be taken in a limiting sense. In the following description, well known functions or constructions are not described in detail since they would obscure the description with unnecessary detail.

The present disclosure discloses a device for detecting a fault in a ground cable. The device may detect a location of the originating substation from where the ground cable, having the fault, is passing through. Further, in the present disclosure, the fault may be identified with the help of an alarm generated at the substation and the colour-coded signal generated by the device. Further, a notification message may be send to a control center.

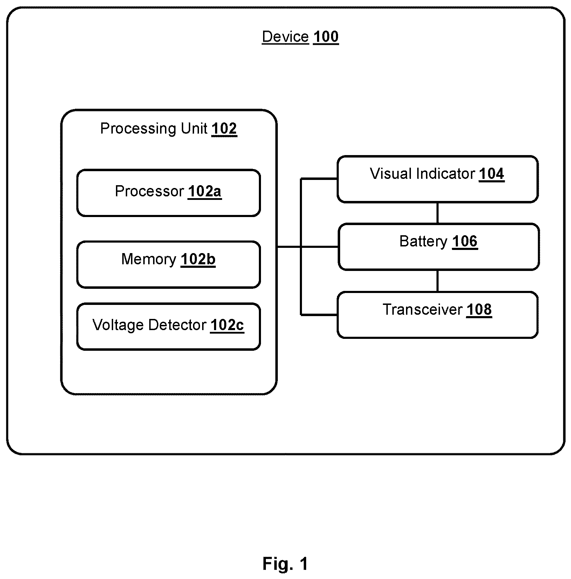

**FIG. 1** illustrates an exemplary block diagram of a device for detecting a fault in the ground cable, in accordance with an embodiment of the present disclosure. Exemplary block diagram illustrates the device 100 configured for detecting the fault in the ground cable. The device 100 may include, without limitation, a processing unit 102, a visual indicator 104, a battery 106, and a transceiver 108. In an embodiment, the processing unit 102 may include, without limitation, a processor 102a, a memory 102b and a verification and a voltage detector 102c.

The memory 102b may store instructions for execution by the processor 102a, including instructions for causing the processor 102a to perform steps or stages consistent with the embodiments described herein. The processor 102a of the processing unit 102 may execute one or more instructions stored in the memory 102b.

In an embodiment, the processing unit 102 may monitor the ground cable passing through an equipment of the electric substation, wherein the equipment is connected with the device 100. As an example, the equipment may be any substation's equipment that operates with high voltage and may be connected to ground, but not limited to, Gas insulated substation (GIS), power transformer, Neutral Grounding Resistor (NGR), as an example. The processing unit 102 may further detect the fault in the ground cable based on the monitoring of the ground cable. The fault in the ground cable may comprise a cut or break in the ground cable or a theft of some part of the ground cable.

In the embodiment, the processing unit 102 may detect the fault in the ground cable by detecting static charge or induced voltage on outer surface of the equipment. If the processing unit 102 determines that the induced voltage on outer surface of the equipment is greater than or equal to a pre-determined voltage threshold then a first colour-coded signal in the visual indicator indicating the fault in the ground cable is activated. However, if the induced voltage on the outer surface of the equipment is lesser than the pre-determined voltage threshold then a second colour-coded signal in the visual indicator, indicating no fault in the ground cable, is activated.

In the embodiment, the processing unit 102 after detecting the fault in the ground cable may generate the alarm in the electric substation along with the first colour-coded signal in the visual indicator indicating the fault in the ground cable. The processing unit 102 in parallel to generating the alarm and the first colour-coded signal, may transmit a notification message to the control center.

In the embodiment, the voltage detector 102c of the processing unit 102 monitors static charges on the outer body of the equipment, by issuing the first colour-coded signal. The voltage detector 102c may be able to detect the break/cut in the ground cable. When there is the break or cut in the ground cable, the static charge start accumulating on the surface of the equipment which may be detected by the voltage detector sensor. The voltage detector 102c in communication with the transceiver 108 may further notifies through the notification message to an appropriate authority/ the control center to take the necessary action.

In the embodiment, the device 100 may send a notification message to the control center, wherein the notification message comprises electric substation data, which in turn comprises location data of the electric substation, name of the electric substation, and identity of the equipment in which the fault is detected. The notification message may further comprises time data of the equipment, wherein the time data indicates occurrence time of the fault detected in the equipment of the electric substation.

In an embodiment, the device 100 may result in efficiently protecting the equipment from current leakage and further effectively warns a technician not to approach the identified equipment in the substation to protect him/her against electric shock. Further, in addition to facilitating maintenance process of the cut in the grounding cable, the device 100 increases reliability of the one or more equipment in the substation based on the quality of grounding system that comprises of one or more ground cables. The device 100 may further help in case of repeated thefts of the ground cable by timely notifying the appropriate authorities of such thefts.

In another embodiment, the visual indicator 102c of the device 100 activates a third color-coded signal indicating a fault in the battery 106 of the device 100. In the embodiment, the fault in the battery 106 may indicate that a battery level of the battery has fallen below a predetermined battery level.

In the embodiment, the visual indicator 102c in communication with the processing unit 102 and the transceiver 108, may send the notification message indication of the fault that the battery level of the battery 106 of the device 102 has fallen below the predetermined battery level. The notification message may further comprise electric substation data, which in turn comprises the location data of the electric substation, name of the electric substation, and identity of the device 100 that is attached to the equipment, where the battery level of the device 100 has fallen below a pre-determined battery level. The notification message may further comprise time data of the device 100, wherein the time data indicates the occurrence of the fault when the battery level of the device 100 has fallen below the pre-determined battery level.

In an embodiment, the device 100 may attach magnetically to the equipment in the electric substation.

In an embodiment, the device 100 may detect the induced voltage on the outer surface of the equipment by monitoring a difference of voltage between two terminals of the main relay coil with an auxiliary contact, which may de-energize in case of loss of the grounding system. The relay coil with the auxiliary contact may detect the fault in the grounding system. After detecting the fault in the grounding system, the auxiliary contact may send an alarm signal to the control center to display the exact location of the equipment inside the substation.

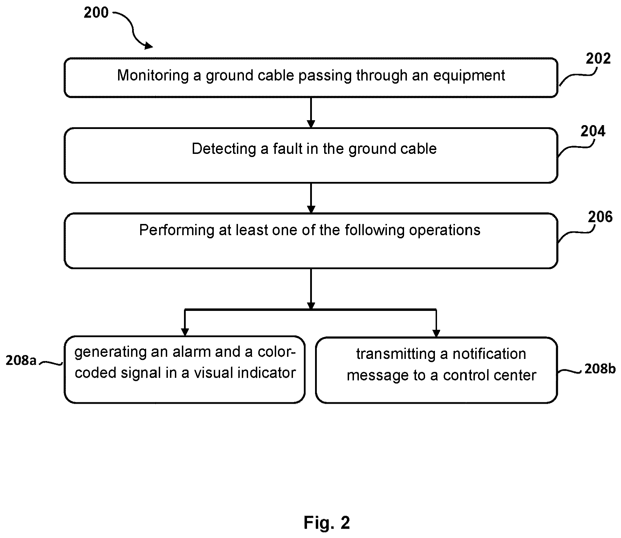

**FIG. 2** illustrates a process flow diagram for detecting a fault in a ground cable, in accordance with an embodiment of the present disclosure.

In an embodiment, a method 200 for detecting a fault in a ground cable is disclosed. The method 200 may comprise multiple steps for detecting the fault in the ground cable.

At step 202, the method may comprise monitoring, by the device 100, the ground cable passing through the equipment of the electric substation, wherein the equipment is connected with the device 100.

At step 204, the method may comprise detecting, by the device 100, the fault in the ground cable based on the monitoring of the ground cable. In the embodiment, the fault in the ground cable comprises the cut in the ground cable.

In the embodiment, the detection of the fault in the ground cable may further comprise detecting, by the device 100, the induced voltage on the outer surface of the equipment. The method may further comprise determining, by the device 100, that the induced voltage on the outer surface of the equipment is greater than or equal to the pre-determined voltage threshold.

At step 206, the method may further comprise performing, upon detecting the fault at the step 204, at least one of the step 208a and 208b.

At step 208a, the method may comprise generating the alarm in the electric substation and the color-coded signal in the visual indicator 104, by the device 100, wherein the visual indicator 104 activates the color-coded signal that indicates the fault on the equipment of the electric substation, based on the fault detected.

In the embodiment, the visual indicator 104 activates another color-coded signal indicating the fault in the device.

At step 208b, the method may comprise transmitting by the device 100, the notification message to the control center.

In the embodiment, the notification message may comprise the electric substation data, which in turn comprises the location data of the electric substation, the name of the electric substation, and the identity of the equipment in which the fault is detected. The notification message further comprises the data of the equipment, wherein the time data indicates occurrence time of the fault detected in the equipment of the electric substation.

The order in which the various operations of the methods are described is not intended to be construed as a limitation, and any number of the described method blocks can be combined in any order to implement the method. Additionally, individual blocks may be deleted from the methods without departing from the spirit and scope of the subject matter described herein. Furthermore, the methods can be implemented in any suitable hardware, software, firmware, or combination thereof.

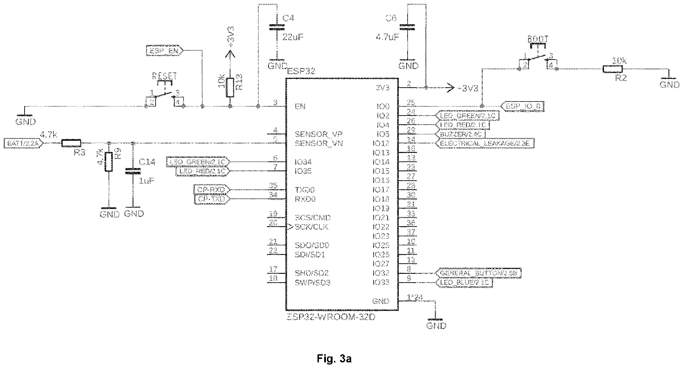

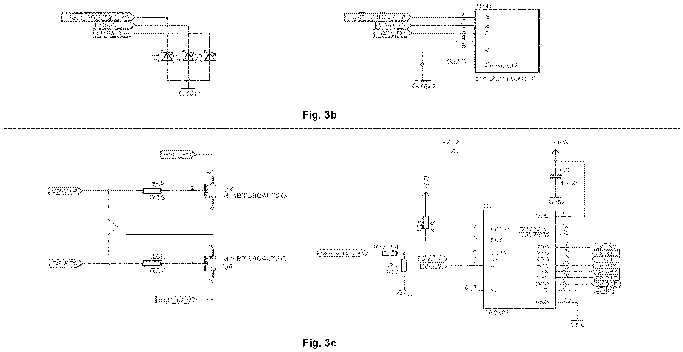

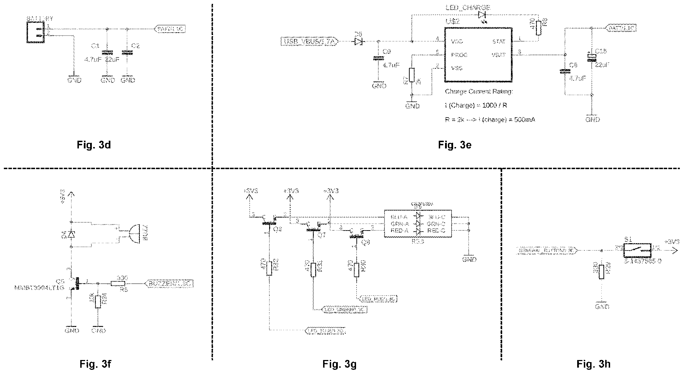

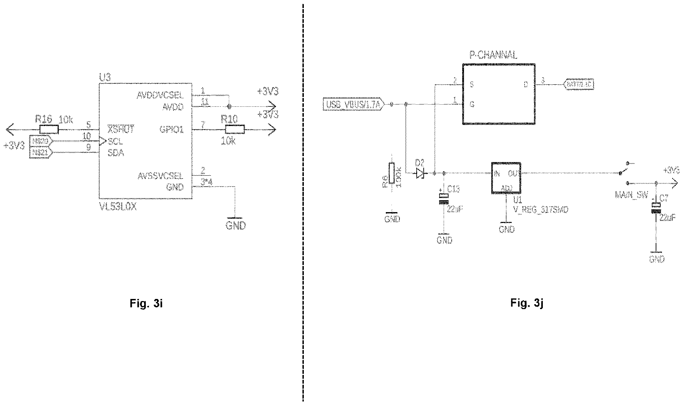

**FIG. 3a** shows an exemplary illustration of a circuit for the processing unit of the device, in accordance with an embodiment of the present disclosure. The circuit illustrates the connections between a microcontroller unit ESP32, as an example, and other pins for analysis of digital and analog signals. Additionally, the circuit may include one or more resistors and one or more push-button switches that may serve as an interface circuit to operate the microcontroller unit.

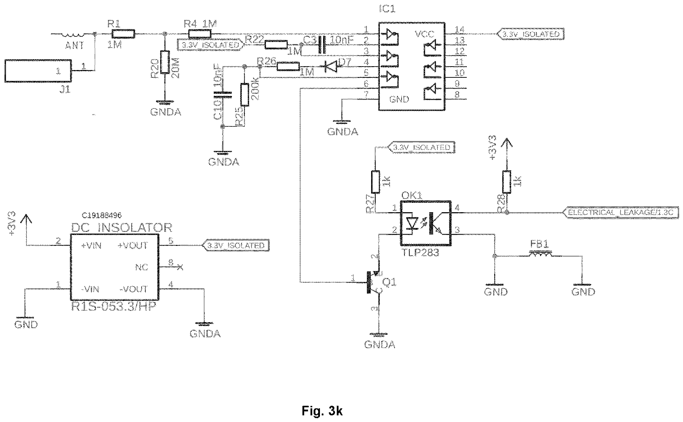

**FIG. 3k** shows an exemplary illustration of a circuit for a voltage detection interface, in accordance with an embodiment of the present disclosure. The circuit is designed to wirelessly detect a signal indicating the induced voltage on the equipment, through a PCB antenna "J1". Following this, a series of electrical filters and buffers may be used to eliminate any unwanted glitches and electromagnetic interference from the detected signal. Additionally, for ensuring accurate voltage measurement, a "DC isolator" may be incorporated to prevent noise and switching harmonics that may be generated by the microcontroller. In the embodiment, the output signal in the final stage may be captured by a photocoupler "OK1" which may further produce a clear digital output.

**FIGs. 3b-3j** shows an exemplary illustration of circuits of the device and related interface, in accordance with an embodiment of the present disclosure. The exemplary circuits as shown in FIGs. 3b-3j resembles the working of the device 100 for efficiently detecting a fault in the ground cable

In the embodiment, the circuits may comprise several components, each performing specific functions to ensure the efficient and reliable operation of the device. The circuit may comprise power supply unit, switching mechanism and other components. The power supply unit may include transformers to step up or step down voltage, rectifiers to convert AC to DC, and voltage regulators to maintain a stable output despite fluctuations in the input power supply.

In the embodiment, the switching mechanism may include switches, relays, and circuit breakers, that control the flow of electricity, allowing the circuits to be turned on or off manually or automatically. Relays may enable automated control by using small electrical signals to operate larger switches, facilitating efficient and remote management of the circuitry.

In the embodiment, the other components may comprise resistors, capacitors, each serving distinct functions. Resistors may limit and regulate the flow of current, ensuring that components receive the appropriate voltage. Capacitors store and release energy, playing a vital role in filtering and stabilizing voltage. Together with active components like transistors and diodes, which amplify and direct electrical signals, these elements form the backbone of complex circuits in the present disclosure. Such components in the circuits of FIGs. 3b-3j efficiently performs the method of the device 100 as illustrated above in multiple steps of the flow diagram of the FIG. 2

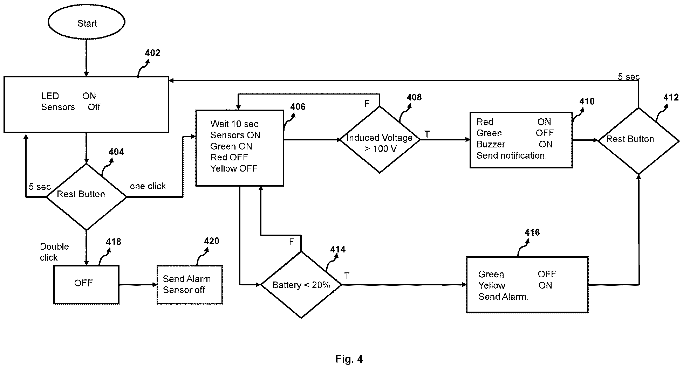

**FIG. 4** illustrates an exemplary decision flow diagram for detecting a fault in a ground cable, in accordance with an embodiment of the present disclosure.

At step 402, after starting the device 100, all Light Emitting Diodes (LEDs) of the smart device will be ON, and all sensors of the device will be OFF. The device 100 has been placed on the equipment of the electric substation.

At step 404, a rest button is clicked by a user. The functionality of the rest button may be used to switch on or off the device 100 and further to perform other functions based on number of times the button is clicked or for how long the rest button has been pressed.

At step 406, when the rest button is clicked, the device 100 starts the operation and wait for a predefined time period for example "10 seconds" to check if the induced voltage on the outer surface of the equipment is within the pre-determined voltage threshold. If yes, a green LED light stays ON, while a red LED and a yellow LED are turned OFF.

At step 408, the induced voltage on the outer surface of the equipment is compared with the pre-determined voltage threshold. If the induced voltage on the outer surface of the equipment of the substation is greater than or equal to a pre-determined voltage threshold, then the flow of the diagram goes to step 410.

At step 410, after the determination that the induced voltage on the outer surface of the equipment of the substation is greater than or equal to a pre-determined voltage threshold, then the red LED is ON, and a buzzer alarm starts ringing in the substation. In parallel, the notification message is transmitted to the control center. The induced voltage on the outer surface of the equipment of the substation is greater than or equal to a pre-determined voltage threshold, signifies the cut/break or theft of the ground cable.

At step 412, when the rest button on the device 100 is continuously pressed for another predefined time period for example "5 seconds", the device 100 then moves to a rest mode of the step 402.

At step 414, when the rest button is clicked at step 406, then the device 100 also determines the battery level of the battery 106. Then at step 414, when the battery level of the battery 106 falls below a predefined value, as an example 20%, then the flow of the diagram goes to step 416.

At step 416, after the determination that the battery level of the battery 106 falls below a predefined value, then the yellow LED will be turned ON. The green LED and the red LED will be turned OFF. The notification message about the low battery of the device 100 is then transmitted to the control center.

After step 416, when the rest button, at step 412, on the device 100 is continuously pressed for example 5 seconds, the device 100 then moves to the rest mode of the step 402.

At step 418, when the rest button is pressed twice in quick succession then the device 100 will be turned OFF.

At step 420, the device 100 will send a notification message to the control center regarding switching OFF the device 100, before the device 100 is turned OFF.

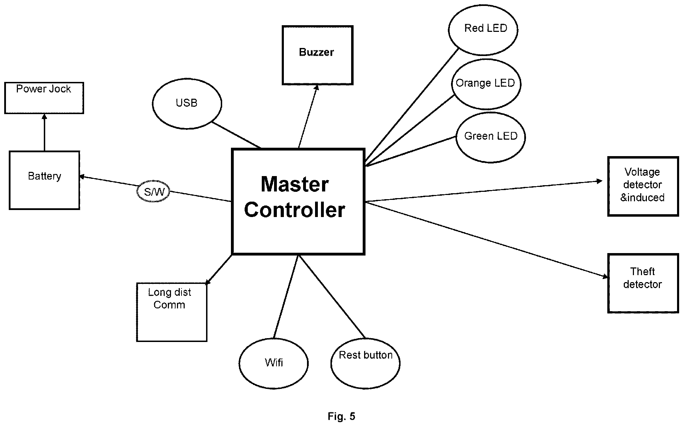

**FIG. 5** illustrates an exemplary depiction of multiple components of the device 100 for detecting the fault in the ground cable, in accordance with an embodiment of the present disclosure.

In FIG. 5, the device 100 may comprise a Master Controller for performing all the operations of the device 100. The Device 100 may comprise a Universal Serial Bus (USB) connection, the rest button, a power jock for charging the battery of the device. The Master Controller of the device 100 may be connected with the buzzer or alarm of the substation through the transceiver like Wi-Fi or long-distance communication. The long-distance communication may be used for transmitting the notification messages. The device 100 may further comprise voltage and theft detector sensor. Lastly, the device 100 may comprise the visual indicator in the form of the red LED, the green LED and the yellow LED.

The various operations of methods described above may be performed by any suitable means capable of performing the corresponding functions. The means may include various hardware and/or software component(s) and/or module(s), including, but not limited to a circuit, an application specific integrated circuit (ASIC), or processor. Generally, where there are operations illustrated in Figures, those operations may be performed by any suitable corresponding counterpart means-plus-function components.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., non-transitory. Examples include Random Access Memory (RAM), Read-Only Memory (ROM), volatile memory, nonvolatile memory, hard drives, Compact Disc (CD) ROMs, Digital Video Disc (DVDs), flash drives, disks, and any other known physical storage media.

Certain aspects may comprise a computer program product for performing the operations presented herein. For example, such a computer program product may comprise a computer readable media having instructions stored (and/or encoded) thereon, the instructions being executable by one or more processors to perform the operations described herein. For certain aspects, the computer program product may include packaging material.

Various components, modules, or units are described in this disclosure to emphasize functional aspects of devices configured to perform the disclosed techniques, but do not necessarily require realization by different hardware units. Rather, as described above, various units may be combined in a hardware unit or provided by a collection of interoperative hardware units, including one or more processors as described above, in conjunction with suitable software and/or firmware.

As used herein, a phrase referring to "at least one" or "one or more" of a list of items refers to any combination of those items, including single members. As an example, "at least one of: a, b, or c" is intended to cover: a, b, c, a-b, a-c, b-c, and a-b-c. The terms "a", "an" and "the" mean "one or more", unless expressly specified otherwise. The terms "including", "comprising", "having" and variations thereof, when used in a claim, is used in a non-exclusive sense that is not intended to exclude the presence of other elements or steps in a claimed structure or method, unless expressly specified otherwise.

Finally, the language used in the specification has been principally selected for readability and instructional purposes, and it may not have been selected to delineate or circumscribe the inventive subject matter. It is therefore intended that the scope of the invention be limited not by this detailed description, but rather by any claims that issue on an application based here on. Accordingly, the embodiments of the present disclosure are intended to be illustrative, but not limiting, of the scope of the invention, which is set forth in the appended claims.

## Claims

1. A method of detecting a fault in a ground cable, the method comprising:
monitoring, by a device, the ground cable passing through an equipment of an electric substation, wherein the equipment is connected with the device;
detecting, by the device, the fault in the ground cable based on the monitoring of the ground cable; and
performing, upon detecting the fault, at least one of:
generating an alarm in the electric substation and a color-coded signal in a visual indicator, by the device, wherein the visual indicator activates the color-coded signal that indicates the fault in the equipment of the electric substation, based on the fault detected; and
transmitting, by the device, a notification message to a control center.

2. The method as claimed in claim 1, wherein the visual indicator activates another color-coded signal indicating a fault in the device.

3. The method as claimed in claim 1, wherein the fault in the ground cable comprises a cut in the ground cable.

4. The method as claimed in claim 1, wherein detection of the fault in the ground cable is based on the monitoring comprises:
detecting, by the device, induced voltage on outer surface of the equipment; and
determining, by the device, that the induced voltage is greater than or equal to a pre-determined voltage threshold.

5. The method as claimed in claim 1, wherein the notification message comprises:
electric substation data comprises location data of the electric substation, name of the electric substation, and identity of the equipment in which the fault is detected; and
time data of the equipment, wherein the time data indicates occurrence time of the fault detected in the equipment of the electric substation.

6. A device for detecting a fault in a ground cable, the device comprising a processing unit configured to:
monitor the ground cable passing through an equipment of an electric substation, wherein the equipment is connected with the device;
detect the fault in the ground cable based on the monitoring of the ground cable; and
perform upon detecting the fault, at least one of:
generate an alarm in the electric substation and a color-coded signal in a visual indicator, by the device, wherein the visual indicator activates the color-coded signal that indicates the fault on the equipment of the electric substation, based on the fault detected; and
transmit a notification message to a control center.

7. The device as claimed in claim 6, wherein the visual indicator activates another color-coded signal indicating a fault in the device.

8. The device as claimed in claim 6, wherein the fault in the ground cable comprises a cut in the ground cable.

9. The device as claimed in claim 6, wherein detection of the fault in the ground cable is based on the monitoring, the processing unit is configured to:
detect induced voltage on outer surface of the equipment; and
determine that the induced voltage is greater than or equal to a pre-determined voltage threshold.

10. The device as claimed in claim 6, wherein the notification message comprises:
electric substation data comprises location data of the electric substation, name of the electric substation, and identity of the equipment in which the fault is detected; and
time data of the equipment, wherein the time data indicates occurrence time of the fault detected in the equipment of the electric substation.
